# EUROPÄISCHE PATENTSCHRIFT

(11) **EP 1 388 593 B1**
(45) Veröffentlichungstag und Bekanntmachung des Hinweises auf die Patenterteilung: **30.12.2015**
(21) Anmeldenummer: 03017033.6
(22) Anmeldetag: 28.07.2003
(51) Int. Cl.: B05D 1/00, B05D 7/00, C23C 16/02, C23C 16/04, C23C 16/30, C23C 16/40, C23C 16/515, C23C 28/00

(54) **Schnelles Verfahren zur Herstellung von Mehrfachlagen-Barriereschichten**
Rapid process for producing multilayer barrier coatings
Méthode rapide de production de revêtements de barrière multicouche

(30) Priorität: 07.08.2002 WO PCT/EP02/08853; 13.12.2002 DE 10258678
(43) Veröffentlichungstag der Anmeldung: 11.02.2004
(73) Patentinhaber: Schott AG, 55122 Mainz (DE)
(72) Erfinder: Bicker, Matthias, Dr., 55126 Mainz (DE); Behle, Stephan, Dr., 55278 Hanheim (DE); Klippe, Lutz, Dr., 65187 Wiesbaden (DE); Lüttringhaus-Henkel, Andreas, 64289 Darmstadt (DE); Arnold, Gregor, 55294 Bodenheim (DE)
(74) Vertreter: Herden, Andreas F.

(56) Entgegenhaltungen:
- EP-A1- 0 451 618
- WO-A1-02/10473
- WO-A2-01/94448
- DE-A1- 19 634 795
- US-A- 5 437 725
- US-A- 5 718 967

## Beschreibung

Die Erfindung betrifft ein schnelles Verfahren zum Aufbringen von Wechselschichten mittels chemischer Gasphasenabscheidungsverfahren, Chemical Vapor Deposition, CVD,nämlich mittels plasmaunterstützter chemischer Gasphasenabscheidungsverfahren PECVD, Plasma Enhanced Chemical Vapor Deposition, und zwar gepulster Plasmaunterstützter chemischer Gasphasenabscheidung PICVD, Plasma Impulse Chemical Vapor Deposition, sowie Beschichtungen, welche nach diesem verfahren aufgebracht werden können.

Um die Durchlässigkeit von Verpackungen für Gase und Flüssigkeiten herabsetzen zu können, sowie das Verpackungsmaterial gegen chemische Angriffe oder UV-Strahlung zu schützen, ist es vorteilhaft, diese Verpackungen mit einer Barrierebeschichtung zu versehen. Hierbei ist beispielsweise das Abscheiden dünner SiOₓ-Beschichtungen oder Beschichtungssysteme auf Polymersubstraten insbesondere für Massenkunststoffe interessant, um deren Durchlässigkeit vor allem für Sauerstoff und Wasserdampf zu reduzieren und insbesondere dabei gleichzeitig die Transparenz des Materials zu erhalten. zudem kann der Inhalt derart beschichteter Materialien in der Regel sicher mittels Mikrowellen verwendenden Einrichtungen erwärmt werden. Ein weiterer Vorteil dieser Beschichtungen liegt in der Vielzahl der Möglichkeiten, diese auf Polymeroberflächen abzuscheiden.

Um die Qualität derartiger Beschichtungen zu verbessern, ist es jedoch nötig, den Zusammenhang zwischen der Barrierewirkung, den morphologischen Eigenschaften und dem molekularen Transports durch die Schicht zu kennen und insbesondere den Einfluss der Abscheidungsbedingungen auf die sich ergebenden Beschichtungsparameter zu beherrschen.

In Erlat et al., J. Mater. Res., (2000) 15 S. 704 bis 716 wird eine Modellvorstellung des Zusammenhangs der Barrierewirkung mit der Schichtmorphologie vorgestellt und der Einfluss verschiedener Prozessparameter beleuchtet.

In Erlat et al., J. Phys. Chem. B (1999) 103, S. 6047 bis 6055 wird die Morphologie der Schichten im Hinblick auf glatte Oberflächen im Hinblick auf Prozessparameter beschrieben. Dabei werden in den beiden zuletzt genannten Zitaten aber nur einzelne anorganische Barriereschichten betrachtet.

Um die Haftungseigenschaften von SiOₓ-Schichten auf Polymersubstraten zu verbessern, wird in Rupertus et al., Fresenius J. Anal. Chem. (1997) 358, S. 85 bis 88, eine Vorbehandlung des Substrats in einem Sauerstoffplasma vorgeschlagen.

Eine Verbesserung des Beschichtungsprozesses wird in herkömmlicher Weise anhand der Prozessparameter Leistung, Druck und Zeit vorgenommen.

Durch anfängliches Vermeiden von Sauerstoff für die 1. Schicht kann nach US-5, 718, 967 A1 eine Haftvermittlerschicht unter Abwesenheit von Sauerstoff und durch anschließendes Einbringen von Sauerstoff darauf eine Schutzschicht unter Sauerstoffüberschuss hergestellt werden.

Ein Verfahren zur Multilayer-Beschichtung von Kunststoff mit Wechselschichten, die aus HMDSO und TiCl₄ hergestellt werden, wird in EP 709485 beschrieben. Dabei werden durch HMDSO organische und durch TiCl₄ anorganische Barriereschichten abgeschieden. Es wird in dieser Anmeldung jedoch nicht beschrieben, wie schnelle Prozesszeiten erreicht werden können und wie der schnelle Prozess für Behälter mit einem größeren Volumen > 18ml, typischerweise > 50ml realisiert werden kann..

Für eine wirtschaftlich Umsetzung eines Barrierebeschichtungsprozesses auf Substrate, wie z.B. PET-Flaschen, ist es notwendig, sehr hohe Probendurchsätze zu realisieren. Typische Probendurchsätze bei Linien, welche Streckblasmaschinen für Kunststoffbehälter und nachgeschaltete Abfüllanlagen umfassen, liegen bei 10 000 bis 30 000 Behältern pro Stunde. Für eine optimale Integration einer in dieser Linie angeordneten Barrierebeschichtungsanlage in der Reihenfolge
1. Streckblasen
2. Beschichten
3. Abfüllen

ist es jedoch nötig und von Vorteil, einen vergleichbaren oder genau so hohen Probendurchsatz für die vorgenommene Barrierebeschichtung zu realisieren. Durch diese Rahmenbedingungen wird jedoch ein sehr schneller Barrierebeschichtungsprozess benötigt, bei dem die reine Beschichtungszeit, in der auf dem Substrat eine Schicht aufwächst, kleiner als 6 s bevorzugt, kleiner als 3,6 s oder sogar kleiner als 1,0 s sein sollte.

Der Probendurchsatz hängt ferner von der Anzahl der auf einer Beschichtungsmaschine benötigten Stationen ab, so dass durch sehr kurze Beschichtungszeiten die Zahl der benötigten Stationen reduziert bzw. umgekehrt bei gleicher Anzahl der Stationen der Probendurchsatz erhöht werden kann, wodurch sich deutliche Kostenvorteile ergeben.

In WO 99/49991 wird eine Barrierebeschichtung mit amorphem Kohlenstoff beschrieben, bei welcher ein schnelles Verfahren mit Beschichtungszeiten im Bereich von 2 bis 3 s erreicht wird. Dort wird jedoch nicht angegeben, welche Permeation bzw. Barriereverbesserung gegenüber dem unbeschichteten Substrat bei vorgegebener Prozesszeit erreicht wird. Diese Schichten sind jedoch nicht transparent, vielmehr besitzen diese eine bräunliche bis gelbe Färbung. Gerade bei transparenten zu beschichtenden Behältern wirkt diese Färbung jedoch sehr unästhetisch und führt oft zu nicht akzeptablen Ergebnissen. Falls diese Schichten dünn aufgebracht werden, ist die Färbung zwar geringer, jedoch immer noch vorhanden. Wenn die Schichtdicke reduziert wird, ist jedoch hierdurch die Barrierewirkung signifikant verschlechtert. Ferner können diese Schichten aus amorphem Kohlenstoff nur sehr schwierig und aufwendig vom PET-Substrat entfernt werden. Aus diesem Grund ist das Recycling der beschichteten Behälter problematisch, weil selbst bei einer Mischung mit unbeschichtetem PET noch ein Farbstich im recycelten Produkt zurückbleiben kann.

Beschichtungszeiten von 2 bis 4 s für eine SiOₓ-Barriereschicht werden auch in den Patentschriften WO 02/09891 A1 und WO 02/10473 beschrieben. Es wird in diesen Veröffentlichungen jedoch nicht angegeben, durch welche Prozessparameter die angegebenen Beschichtungszeiten eingestellt werden können. Es fehlen insbesondere genaue Angaben zu Druck, Konzentration, Mikrowellenleistung und Precursor- sowie zu den Träger- und Reaktivgasflüssen.

In der WO2/10473 wird außerdem ein Verfahren zur Beschichtung von kunststoffflaschen offenbart, wobei Zunächst eine Barriereschicht aus Siliziumdioxid und sodann eine organische Schicht auf das Substrat aufgebracht wird. Die Schichten, welche aus verschiedenen Ausgangsverbindungen aufgebracht werden, bestehen aus einer Schutzschicht aus amorphem Kohlenstoff, einer SiOx-Schicht und einer Grenzschicht zum Substrat, hergestellt aus Sauerstoff und einer "Organo-Silzium-haltigen" Verbindung. Dieses Verfahren ist sehr aufwendig, da insgesamt 3 Schichten aufgebracht werden und stark unterschiedliche Ausgangsverbindungen verwendet werden müssen. Auch in den Ansprüchen 1-10 der WO 02/09891 A1 wird ein ähnlich aufwendiges Verfahren beschrieben.

Ausgehend von den vorstehend beschriebenen bekannten Verfahren liegt eine Aufgabe der Erfindung darin, ein möglichst optimal in eine Produktionslinie integrierbares Verfahren zum Aufbringen qualitativ hochwertiger Barriereschichten auf ein Substrat, wie beispielsweise auf die innere Oberfläche einer Kunststoffflasche, zur Verfügung zu stellen.

Gelöst wird diese Aufgabe auf überraschend einfach Weise bereits durch die Merkmale des Anspruchs 1. Ferner ist in Anspruch 30 ein Verbundmaterial angegeben, welches mit dem erfindungsgemäßen Verfahren herstellbar ist.

Vorteilhafte Weiterbildungen finden sich jeweils in den zugeordneten Unteransprüchen.

In der Anmeldung PCT/EP/02 08 853 mit dem Titel "Verbundmaterial aus einem Substratmaterial und einem Barriereschichtmaterial" hat der Anmelder ein Verfahren zur Herstellung eines Verbundmaterials mit einer verbesserten Barrierewirkung und einer verbesserten Haftung vorgeschlagen. Die Anmeldung PCT/EP/02 08 853 wird in der vorliegenden Anmeldung als Prioritätsdokument beansprucht.

Bei dem erfindungsgemäßen Verfahren werden Wechselschichten allein aus einem Precursormaterial hergestellt. Dadurch ist eine schnelle und einfach zu realisierende Prozessführung möglich, welche auch insbesondere die im Anspruch 1 angegebenen schnellen Prozesszeiten ermöglicht.

Ein Übergang zwischen organischen und anorganischen Schichten kann variabel gestaltet werden, und es lassen sich zudem sehr glatte Schichten aufbringen, wobei durch die Grenzflächen zwischen organischen und anorganischen Schichten eine Verstärkung der Barrierewirkung erreicht wird.

Die Erfindung sieht vor, den Gesamtfluss für die zweite anorganische Schicht gegenüber dem Gesamtfluss für die erste organische Haftvermittlerschicht gleich groß zu lassen oder zu erhöhen. Vorteilhafterweise kann damit für den zuletzt genannten Fall die Abscheiderate für die zweite Schicht deutlich gesteigert werden, so dass die gesamte Beschichtungszeit nochmals reduziert werden kann. Durch eine Erhöhung des Gesamtflusses kann bei niedriger Precursorkonzentration die Qualität der Barriereschicht beibehalten und gleichzeitig die Abscheiderate deutlich gesteigert werden, so dass für die zweite anorganische Barriereschicht bei gleicher Schichtdicke eine deutlich reduzierte Beschichtungszeit ermöglicht wird.

Die erfindungsgemäße Lösung stellt damit erstmals ein Verfahren zum Aufbringen von Wechselschichten, das heißt von mindestens 2 Schichten, durch PECVD-, insbesondere PICVD-Verfahren zur Verfügung, welches die Verfahrensschritte des schnellen Abscheidens einer Haftvermittlerschicht auf einem Substrat und des Aufbringens einer Sperrschicht umfasst, wobei alternierend Wechselschichten aus organischen und anorganischen Materialien abgeschieden werden. Vorzugsweise werden nur 2 Schichten abgeschieden. Damit können besonders schnelle Prozesszeiten realisiert werden.

Die Wechselschichten können vorteilhafterweise aus nur einem einzigen Precursorgas Precursorgasen abgeschieden werden, nämlich Hexamethyldisiloxan oder Hexamethyldisilazan für beide Schichten oder Hexamethyldisiloxan für die erste organische und Hexamethyldisilazan für die zweite anorganische Schicht.

Das Verfahren ist dadurch gekennzeichnet, dass die Beschichtungszeit zum Aufbringen der Haftvermittlerschicht zwischen 0,05 s und 4 s liegt, und/oder die Beschichtungszeit zum Aufbringen der Sperrschicht zwischen 0,1 s und 6 s liegt. Mit "Beschichtungszeit" ist dabei die Zeitdauer gemeint, in der eine Schicht auf dem Substrat abgeschieden wird und während der ein kontinuierliches oder ein gepulstes Plasma brennt.

Für eine effiziente Herstellung von Sperrschichten, insbesondere auf dielektrischen Materialien, ist es notwendig, glatte Schichten mit einer geringen Dichte an inneren Grenzflächen oder anderen Inhomogenitäten abzuscheiden. Eine hohe Dichte an topologischen oder chemischen Inhomogenitäten kann zu einer erhöhten Durchlässigkeit der Schicht führen.

Dies ist vor allem dann der Fall, wenn kurze Diffusionspfade entlang der Inhomogenitäten vorhanden sind, durch die im Vergleich zum Volumen eine schnelle Diffusion ablaufen kann. Zum Beispiel lässt sich in der Regel mit sehr porösen Schichten keine gute Barrierewirkung erzielen. Bevorzugt sind daher Schichten mit einer geringen Dichte an kurzen Diffusionswegen, wie zum Beispiel amorphe Schichten mit einer niedrigen Dichte an inneren Grenzflächen bzw. polykristalline Schichten mit einer niedrigen Dichte an Korngrenzen.

Die Diffusion durch die Grenzflächen zwischen organischen und anorganischen Schichten wird bei Wechselschichten deutlich gehemmt bzw. der Diffusionsweg wird deutlich verlängert.

Durch geeignet gewählte Prozessparameter können sowohl sehr glatte anorganische als auch sehr glatte organische Schichten abgeschieden werden. In der am 13.12.2002 von der Anmelderin eingereichten Anmeldung DE 102 58 681 A1 mit dem Titel "Verfahren zum Herstellen von glatten Barriereschichten und Verbundmaterial mit glatter Barriereschicht" schlägt der Anmelder eine Vorrichtung und ein Verfahren zum Herstellen sehr glatter Barrierewechselschichten vor.

Um den erfindungsgemäß sehr schnellen Prozess auf einfache Weise realisieren zu können, werden die erfindungsgemäßen Wechselschichten durch Variation von zumindest einem Prozessparameter abgeschieden.

Die Erfinder haben herausgefunden, dass durch den Einsatz eines plasmaunterstützen CVD-Verfahrens, eines sogenannten PICVD-Verfahrens, besonders gut haftende Schichten mit einer hervorragenden Barrierewirkung in einer sehr kurzen Prozesszeit abgeschieden werden können. Mit Hilfe der PICVD-Technik können sehr dünne Schichten auf ein Substratmaterial aufgebracht werden, die dennoch sehr gute Barriereeigenschaften aufweisen. Die Schichten haben zudem eine hohe Flexibilität.

Die Verwendung eines PICVD- Verfahrens ermöglicht des Weiteren den Einsatz auf Mehrplatzanlagen, was insbesondere einen hohen Durchsatz ermöglicht.

Bei dem erfindungsgemäßen Verfahren wird beim Abscheiden der Schichten ein mittels Mikrowellen erzeugtes Plasma eingesetzt. Vorzugsweise finden dabei Mikrowellen einer Frequenz von 2,45 GHz Verwendung. Zudem ist vorgesehen, dass das mittels Mikrowellen erzeugte Plasma gepulst wird.

Durch einen erhöhten Gesamtfluss ändert sich das Strömungsprofil im Behälter. Es zeigte sich, dass abhängig vom Gasfluss insbesondere für die anorganische Barriereschicht die Lanzenlänge, mittels welcher das Precursorgas in den zu beschichtenden Behälter eingebracht wurde, vorteilhaft angepasst werden kann, um in dem Behälter eine gleichmäßige Verteilung der Komponenten im Prozessgas realisieren zu können. Die Lanzenlänge ist dabei definiert als der Abstand zwischen der Öffnung, aus der Gas in den zu beschichtenden Behälter strömt und der Außenkante der Behälteröffnung des zu beschichtenden Behälters, welche gegen die Atmosphäre abgedichtet wird. Bei dieser Anpassung wird die Schichtdickenverteilung für die organische Schicht nur geringfügig geändert.

Neben der Lanzenlänge sieht die Erfindung vor, auch die Pulspause an einen erhöhten Gesamtfluss anzupassen. Dabei wird bei höherem Gesamtfluss die Pulspause verkürzt.

Die Pulspause bestimmt die Zeitdauer, in der frisches Prozessgas in den Behälter einströmen kann, bevor ein Plasma gezündet wird und die Beschichtung erfolgt. Bei optimierter Strömung im Hinblick auf den Druck, den Gesamtfluss, die Precursorkonzentration, die Lanzenlänge sowie den Düsendurchmesser kann eine gute Verteilung der Komponenten des Prozessgases bereits bei kürzeren Pulspausen erreicht und somit der Verfahrensablauf nochmals beschleunigt werden.

Es ist zu beachten, dass die Abscheiderate bei gepulsten Plasmen nicht zwingend niedriger als bei sogenannten "Continuous Wave-Plasmen (CW-Plasmen)" sein muss, weil bei geeignet bestimmten Parametern beim gepulsten Plasma innerhalb der Pulsdauer eine nahezu vollständige Stoffumsetzung stattfinden kann und innerhalb der Pulspause neues Frischgas einströmt, das beim nächsten Puls wieder nahezu vollständig umgesetzt wird.

Die Abscheiderate bei gepulsten Plasmen kann sogar höher sein, wenn das frische Prozessgas zeitgerecht einströmt und dann während des Pulses mit hoher Pulsleistung eine höhere Stoffmengenumsetzung stattfindet als bei einem CW-Plasma mit niedrigerer Momentanleistung. Mit kürzerer Pulspause nimmt die Abscheiderate bis zu einem Optimum deutlich zu, da der Anteil an umgesetztem Precursorgas bis zur Sättigung steigt.

Erfindungsgemäß liegt die Abscheiderate für die organische Schicht im Bereich von 120 nm/min bis 5000 nm/min, vorzugsweise im Bereich von 500 nm/min bis 2000 nm/min, und/oder für die anorganische Schicht im Bereich von 60 nm/min bis 2000 nm/min, vorzugsweise im Bereich von 100 nm/min bis 1000 nm/min.

Folglich kann durch Verkürzung der Pulspause eine deutlich niedrigere Beschichtungszeit erreicht werden, wobei sich ein Optimum ausbildet, denn bei zu kurzer Pulspause wird die Uniformität der Beschichtung zu schlecht, weil sich keine gleichmäßige Verteilung der Komponenten des Prozessgases ausbilden kann.

Die Uniformität ist definiert als das Verhältnis der minimalen Schichtdicke zur maximalen Schichtdicke, wobei die Werte durch Messung über das genannte Substrat ermittelt werden.

Bei zu langer Pulspause steigt hingegen der Anteil an unverbrauchtem Prozessgas an. Mit zunehmendem Gesamtfluss wird erfindungsgemäß die Lanzenlänge reduziert. Die Lanzenlänge liegt bei Werten im Bereich von 5 % bis 80 %, vorzugsweise im Bereich von 10 % bis 50 % der Höhe eines zu beschichtenden Hohlkörpers.

Ein weiterer Vorteil des gepulsten Plasmas ist, dass sehr reine anorganische Barriereschichten hergestellt werden können, weil im Gegensatz zum CW-Plasma unerwünschte organische Reaktionsprodukte in der Pulspause entfernt werden können und somit ein deutlich geringerer Anteil an organischen Bestandteilen in den Schichten eingebaut wird.

Zusätzlich zu den vorstehend genannten Vorteilen des PICVD-Verfahrens wird damit die Möglichkeit geschaffen, für das schnelle Abscheiden von Wechselschichten aus einem einzigen weitere Prozessparameter zur Steuerung des Verfahrens zur Verfügung zu stellen.

Der zumindest eine zu variierende Prozessparameter wird aus der Gruppe ausgewählt, die die Precursorkonzentration, die mittlere Mikrowellenleistung, den Druck, die Pulsleistung, die Pulsdauer, die Dauer der Pulspause und den Gesamtfluss umfasst. Diese Parameter bieten die Möglichkeit bei sehr kurzer Beschichtungszeit dennoch qualitativ hochwertige Barriereschichten abzuscheiden. Alle genannten Prozessparameter beziehen sich auf die Beschichtung von einem einzelnen Substrat. Für die Beschichtung von vielen Substraten in einer Mehrplatzanlage, beispielsweise einer Rundläufer- oder Batch-Anlage mit mehreren Kammern, beziehen sich die genannten Parameter jeweils auf die Beschichtung in einer einzelnen Kammer.

Als optimale Pulspausen ergaben sich für die organische Schicht Werte im Bereich von 2 ms bis 100 ms, vorzugsweise zwischen 5 ms und 60 ms, und für die anorganische Schicht zwischen 5 ms und 200 ms, vorzugsweise 20 ms und 50 ms.

Erfindungsgemäß werden dafür die Parameter auf optimale Werte eingestellt.

Insbesondere ist vorgesehen, dass die Precursorkonzentration zum Aufbringen der ersten organischen Haftvermittlerschicht im Bereich 5 % bis 80 % des Gesamtflusses liegt und/oder dass die Precursorkonzentration zum Aufbringen der zweiten anorganischen Barriereschicht im Bereich von 0,5 % bis 4 % vorzugsweise zwischen 0,8 % und 3 % des Gesamtflusses liegt.

Des Weiteren ist vorgesehen, dass die Pulsleistung für die organische Schicht im Bereich von 100 W bis 5000 W, vorzugsweise im Bereich von 400 W und 1500 W, liegt, und/oder dass die Pulsleistung für die zweite anorganische Schicht im Bereich von 100 W bis 5000 W, vorzugsweise im Bereich von 400 W bis 1500 W liegt.

Die mittlere Mikrowellenleistung liegt erfindungsgemäß für die organische Schicht im Bereich von 10 W und 5000 W, vorzugsweise im Bereich von 10 W und 500 W, und/oder für die anorganische Schicht im Bereich von 10 W bis 5000 W, vorzugsweise im Bereich von 30 W und 2000 W.

Die Barrierebeschichtung kann auch besonders vorteilhaft eine senkrecht zur beschichteten Oberfläche des Substrats variierende Zusammensetzung oder Struktur aufweisen. Die Variation kann dabei stetig oder stufenweise sein.

Eine stufenweise Variation ergibt eine mehrschichtige Barrierebeschichtung. Beispielsweise kann die unterste Schicht, die mit der Oberfläche des Substrats in Kontakt ist, als Haftvermittlerschicht für die darauffolgenden Beschichtungen dienen. Solche Schichten oder Schichtsysteme können zum Beispiel durch kontinuierliche oder stufenweise Änderung der Precursorkonzentration während der Beschichtung hergestellt werden.

Besonders gute Beschichtungseigenschaften lassen sich dabei mit Mehrfachwechselschichten, sogenannten Multilayern, erreichen.

Das zu beschichtende Substratmaterial kann auch insbesondere einen Hohlkörper umfassen. Mit dem erfindungsgemäßen Verfahren kann so eine Beschichtung auf der Innenseite und/oder der Außenseite des Hohlkörpers abgeschieden werden.

In der am 13.12.2002 beim Deutschen Patent- und Markenamt eingereichten Anmeldung DE 102 58 681 A1 der Anmelderin der vorliegenden Anmeldung mit dem Titel " Verfahren zum Herstellen von glatten Barriereschichten und Verbundmaterial mit glatter Barriereschicht" wird eine Vorrichtung zum Aufbringen von Barriereschichten auf Hohlkörper als Substrat beschrieben.

Die Erfindung sieht ferner vorteilhaft vor, als Substrat einen Hohlkörper, vorzugsweise gleichzeitig, außenseitig auf einen Druck p₁ zu evakuieren und innenseitig auf einen Basisdruck p₂ < p₁ abzupumpen, wobei der Druck p₁ insbesondere im Bereich um 50 mbar und der Basisdruck p₂ insbesondere unterhalb von 0,1 mbar liegt.

Des Weiteren ist für das erfindungsgemäße Verfahren vorgesehen, ein den Precursor enthaltendes Gasgemisch bei einem Druck p₃ mit p₂ < p₃ < p₁ in den Innenraum des Substrats zu leiten, wobei der Druck p₃ insbesondere für die erste organische Schicht im Bereich von 0,1 mbar bis 1,0 mbar, vorzugsweise im Bereich von 0,2 mbar bis 0,5 mbar, und für die zweite anorganische Schicht im Bereich von 0,1 mbar bis 1,0 mbar, vorzugsweise im Bereich von 0,25 mbar bis 0,6 mbar liegt. Damit wird vorteilhafterweise erreicht, dass auf die Wandungen des Hohlkörpers keine zu großen Druckunterschiede wirken, die bei dünnwandigem Material zur Verformung des Hohlkörpers führen könnten.

Ferner kann es für die ausschließliche Innenbeschichtung vorteilhaft sein, den Außendruck so zu wählen, dass im Außenraum kein Plasma gezündet wird. Um bereits während des Abpumpens große Druckunterschiede zu vermeiden, kann dabei vorteilhaft zunächst gleichmäßig so abgepumpt werden, dass der vorstehend genannte Außendruck erreicht wird und dann anschließend nur innenseitig bis zu einem Basisdruck im angegebenen Bereich abzupumpen.

Bei dem Verfahren ist vorteilhaft der Gesamtfluß und/oder der Druck p₃ im Innenraum des Substrats beim Abscheiden der anorganischen Sperrschicht zumindest gleich, insbesondere höher als der Gesamtfluß und/oder der Druck p₃ im Innenraum des Substrats beim Abscheiden der organischen Haftvermittlerschicht. Daher kann mit der Erfindung eine deutlich höhere Abscheiderate beim Aufbringen der anorganischen Sperrschicht erreicht werden als bei einem niedrigeren Gesamtfluß.

Das Prozeßgas für eine Schicht wird erfindungsgemäß bei einem Druck p₄ eingelassen, welcher höher ist als der Druck p₅ unmittelbar vor dem Zünden des Plasmas. So kann der Befüllvorgang schnell und effizient durchgeführt werden. Während des Aufbringens einer Schicht fällt der Prozeßdruck bis zum Beginn des Aufbringens der folgenden Schicht dann kontinuierlich ab, und die Temperatur steigt während des Aufbringens der Beschichtung kontinuierlich.

Erfindungsgemäß liegt der Gesamtfluss für die organische Haftvermittlerschicht im Bereich von 10 sccm bis 250 sccm, vorzugsweise im Bereich von 40 sccm bis 100 sccm, und für die anorganische Schicht im Bereich von 200 sccm bis 1000 sccm, vorzugsweise im Bereich von 250 sccm bis 400 sccm.

Das Verfahren zeichnet sich außerdem dadurch aus, dass beim Wechsel der Prozeßparameter beim Übergang zwischen zwei Beschichtungsschritten das Plasma entweder weiter brennt oder für eine Übergangszeit unterbrochen wird. Damit wird durch die Erfindung ein weicher kontinuierlicher Übergang in Form eines Gradienten oder ein harter Übergang in Form einer Stufe ermöglicht und ferner die Möglichkeit zur Energieeinsparung gegeben. Insbesondere ist die Übergangszeit für ein gepulstes Plasma größer als die Pulspause.

Das erfindungsgemäße Verfahren macht grundsätzlich eine Vorbehandlung des Substrats überflüssig. Im Fall besonders kritischer Substrate, die beispielsweise aus einem Material bestehen, auf dem die Haftung der Beschichtung nicht zufriedenstellend ist, kann jedoch mit dem Verfahren auch vor dem Aufbringen der Beschichtung eine Plasmavorbehandlung durchgeführt werden. Um dennoch die hohe Geschwindigkeit des erfindungsgemäßen Verfahrens dadurch nicht herabzusetzen, liegt die Dauer der Plasmavorbehandlung unterhalb von 5 s, vorzugsweise unterhalb von 1 s.

Um die Möglichkeiten zur Prozesssteuerung zu erweitern und synergistische Effekte nutzbar zu machen, ist des Weiteren vorgesehen, eine Kombination von Prozessparametern zu variieren.

Je nach den Anforderungen an die Beschichtung können mit dem erfindungsgemäßen Verfahren Schichten mit unterschiedlichen Eigenschaften hergestellt werden. Zum Beispiel kann eine Vorgabe darin liegen, insbesondere für eine verbesserte Barrierewirkung definierte Grenzflächen in der Beschichtung zu fertigen. Daher umfasst die erfindungsgemäße Lösung verschiedene Möglichkeiten zur Variation der Prozessparameter. Der zumindest eine Prozessparameter kann kontinuierlich oder diskontinuierlich variiert werden, alternativ kann der zumindest eine Prozessparameter teilweise kontinuierlich und/oder teilweise diskontinuierlich variiert werden.

Bei dem erfindungsgemäßen Verfahren wird vorteilhaft zunächst eine organische Schicht auf dem Substrat als Haftvermittlerschicht abgeschieden. Dadurch wird eine bessere Haftung weiterer Schichten, insbesondere einer Barriereschicht, ermöglicht.

Beim Abscheiden der Haftvermittlerschicht erfolgt eine Fragmentierung des Precursors. Durch geeignete Wahl der Prozessparameter wird die Fragmentierung des Precursors derart beeinflusst, dass einzelne Fragmente in Form von Atomen, Molekülen, Ionen oder Radikalen mit den Molekülen des zu beschichtenden Substrats reagieren und eine chemische Bindung (Chemisorption) eingehen. Diese Bindung wird gegenüber einer Physisorption bevorzugt. Durch die starke Bindung in Folge der Fragmentierung des Precursors wird die Schichthaftung verbessert. Durch die Fragmentierung entsteht insbesondere eine organische Haftvermittlerschicht mit einem Kohlenstoffgehalt von mehr als 10 %.

Durch die Prozessparameter wird das Wachstum der Haftvermittlerschicht weiterhin derart beeinflusst, dass die organische Schicht vorteilhafterweise im Lagenwachstum auf dem Substrat abgeschieden wird und nur wenige Defekte in Form von inneren Grenzflächen aufweist. Die Haftvermittlerschicht ist damit sehr glatt und kann bereits selbst eine Barrierewirkung besitzen, weil sie nur sehr wenige Grenzflächen besitzt, die als Pfade für eine schnelle Diffusion dienen könnten.

Unter geeigneten Bedingungen ist es zudem möglich, durch die Haftvermittlerschicht einen Glättungseffekt auf einem rauhen Kunststoffsubstrat zu erreichen. Ein Vorteil der glatten Haftvermittlerschicht ist, dass auf dieser eine anorganische Schicht mit guter Barrierewirkung aufgebracht werden kann, während bei Haftvermittlerschichten mit rauher Morphologie nur eine anorganische mit einer deutlich reduzierten Sperrwirkung aufgebracht werden kann. Die verwendete anorganische Barriereschicht reicht auch bei unpolaren Kunststoffen, wie zum Beispiel Polypropylen, für eine gute Schichthaftung aus. Es ist dabei ein verfahrenstechnischer Vorteil, dass das erfindungsgemäße Verfahren auf eine zeitintensive Plasmavorbehandlung zur Aktivierung der Oberfläche, wie sie zum Beispiel durch ein Sauerstoffplasma gemäß den vorstehend zitierten Dokumenten erfolgen könnte, verzichtet werden kann.

Gemäß dem erfindungsgemäßen Verfahren wird eine anorganische Schicht als Sperrschicht abgeschieden. Vorteilhafterweise wird durch diese Sperrschicht die Barrierewirkung aufgrund der Grenzflächen zwischen den organischen und den dichten, ebenfalls glatten, anorganischen Schichten verstärkt. Durch einen Sprung in der Morphologie, zum Beispiel vom Lagenwachstum zum Säulenwachstum oder zum Inselwachstum, werden die Diffusionspfade entlang der Grenzflächen deutlich verlängert. Außerdem liegen an den Grenzflächen veränderte Bindungsverhältnisse im Vergleich zum Inneren der Schichten vor, wodurch die Permeation in diesen Bereichen erschwert wird.

Das erfindungsgemäße Verfahren lässt sich unter Verwendung unterschiedlicher Precursor durchführen, insbesondere ist vorgesehen, dass das Gasgemisch Sauerstoff und einen Precursor HMDSN oder HMDSO enthält.

Indem die Verfahrensschritte des Aufbringens einer ersten und einer zweiten Schicht wiederholt werden, wobei die Wechselschichten insbesondere auf einem dielektrischen Material und/oder auf Kunststoff abgeschieden werden, ermöglicht das erfindungsgemäße Verfahren das Aufbringen von Barrierebeschichtungen mit besonders langen Diffusionspfaden, wobei das Verfahren vorteilhafterweise für Verpackungen, insbesondere Verpackungen aus Kunststoff angewendet werden kann.

Die Erfindung umfasst neben dem Verfahren ein aus Wechselschichten bestehendes Verbundmaterial, welches alternierend aus organischen und anorganischen Materialien, die aus einem einzigen Precursorgas abgeschieden wurden, besteht.

Das Verbundmaterial weist ferner vorteilhaft eine erhöhte Barrierewirkung, eine erhöhte Haftung auf dem Substrat, eine erhöhte Dehnbarkeit, eine erhöhte mechanische Stabilität unter Druckbelastung und/oder eine erhöhte mechanische Stabilität unter Druckbelastung auf. Nach Dehnungen und/oder plastischen Verformungen mit Längenänderungen von mehr als 4% verbleibt bei dem erfindungsgemäßen Verbundmaterial eine Barriereverbesserung mit einem Sauerstoffbarriereverbesserungsfaktor größer als 1,5, vorzugsweise größer als 2,0.

Ein Vorteil des Verbundmaterials liegt auch darin, dass es gerade unter Dehnbelastung durch karbonisierte, unter Überdruck stehende Flüssigkeiten, eine hohe mechanische Stabilität aufweist. Behältnisse aus dem erfindungsgemäßen Verbundmaterial sind daher für solche Flüssigkeiten besonders geeignet. Damit bietet die erfindungsgemäße Beschichtung im allgemeinen Vorteile bei der Verwendung insbesondere auf Substraten, die Behältnisse für geschäumte Produkte oder Produkte mit gelösten Gasen umfassen oder bilden.

Die Beschichtung weist zumindest eine organische Haftvermittlerschicht auf, deren Dicke im Bereich von 1 nm bis 200 nm liegt, und zumindest eine anorganische Sperrschicht mit einer Dicke von 5 nm bis 200 nm.

Die Erfindung macht es erstmals möglich, derart gute Schichtqualitäten in schnellen Prozesszeiten unterhalb von 6 s zu produzieren, dass bereits mit den Schichtdicken im genannten Bereich die Anforderungen an die Barrierewirkung, die Haftung, die Dehnbarkeit und die mechanische Stabilität unter Druckbelastung erfüllt werden können.

Aufgrund der geringen erforderlichen Schichtdicken wird eine Materialersparnis möglich. Zudem wird die erforderliche Beschichtungszeit reduziert, denn je dünner die Schicht sein muss, desto kürzer darf die Beschichtungszeit gewählt werden. Auf diese Weise ermöglicht die erfindungsgemäße Beschichtung die Anwendung eines sehr schnellen Beschichtungsverfahrens bei überraschend hoher Qualität der Barriere.

Das Verbundmaterial ist zudem temperaturbeständig. Die Temperaturbeständigkeit ist dabei dadurch definiert, dass nach Heißbefüllung die Schichten haften und eine Barrierewirkung vorhanden ist. Insbesondere bei Temperaturbelastung durch eine Heißabfüllung bietet die Erfindung damit den Vorteil, dass im wesentlichen keinerlei Ablösung der Barrierebeschichtung infolge der Temperaturbelastung erfolgt, und dass auch noch nach der Temperaturbelastung immer noch eine gute Barrierewirkung vorliegt.

Die erfindungsgemäße Beschichtung weist ferner eine gute Beständigkeit gegenüber der Befüllung mit heißen Flüssigkeiten auf, wie diese zum Beispiel für HOT-FILL-Flaschen oder Behältern für andere Produkte, die für eine Heißabfüllung eingesetzt werden, erforderlich ist. Auch bei diesen Behältern kann der Prozess mit einer sehr kurzen Beschichtungszeit umgesetzt werden.

Zusätzlich zu der zumindest einen Wechselschicht aus organischer und anorganischer Beschichtung kann das Verbundmaterial eine Deckschicht umfassen. So kann, je nach Anforderungen an das beschichtete Substrat, eine Schutzschicht zur Verfügung gestellt werden.

Zudem kann die Deckschicht Beschriftungen oder andere Gestaltungen des beschichteten Substrats umfassen.

Das erfindungsgemäße Verbundmaterial ist, anders als bei herkömmlichen Kohlenstoff-basierten Verfahren, im wesentlichen transparent. Mit "transparent" wird eine Schicht bezeichnet, welcheim sichtbaren Wellenlängenbereich transparent ist, was bedeutet,dasss der visuelle Transmissionsgrad (Lichtart D65) nicht geringer ist als für eine unbeschichtete Flasche. Damit können mit der Erfindung Behältnisse hergestellt werden, bei denen einerseits das Produkt von außen unverfälscht erkannt werden kann und die es andererseits erlauben, den Inhalt optisch zu überwachen. Dies kann bei Anwendungen in der Medizintechnik oder der Biotechnologie, etwa bei photometrischen Messungen, wichtig sein.

Im Bereich der Lebensmittel- oder Kosmetikverpackungen ist eine transparente Verpackung zum einen attraktiv für den Verbraucher, zum anderen kann der Inhalt leicht und sicher auf Verderb überprüft werden.

Die Erfindung wird nachfolgend anhand von Ausführungsbeispielen und unter Bezugnahme auf die beigefügte Abbildung beschrieben.

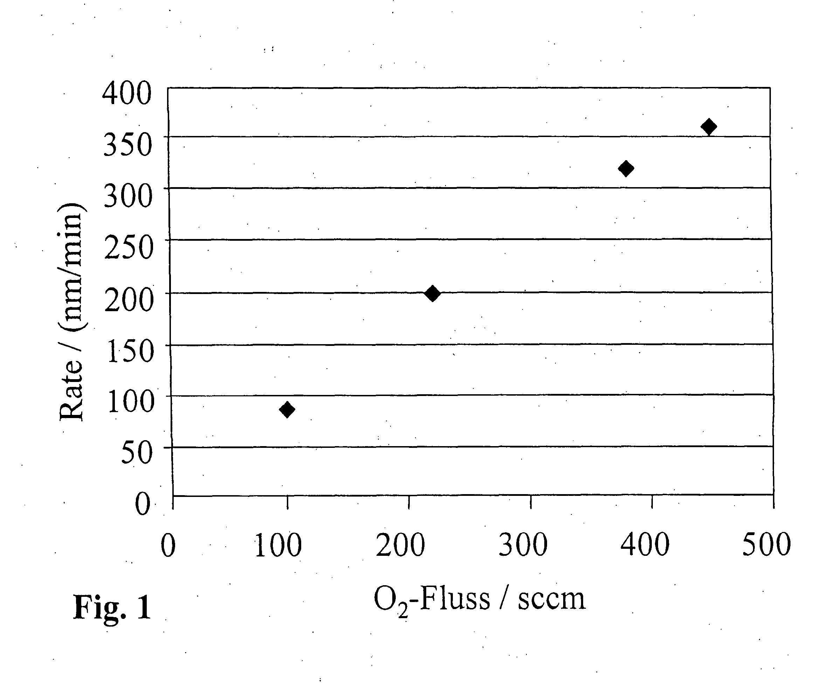

Es zeigt
- Fig. 1: die Abscheiderate einer zweiten anorganischen Barriereschicht in Abhängigkeit vom Sauerstofffluss.

### Erstes Ausführungsbeispiel

### Innenbeschichtung einer 0,4 1 PET-Flasche mit einem Haftvermittler-Barriereverbund

Eine Flasche aus Polyethylenterephtalat (PET) mit einem Füllvolumen von 0,4 l wird gleichzeitig außenseitig auf einen Druck von 50 mbar evakuiert und innenseitig zunächst auf einen Basisdruck unterhalb von 0,1 mbar abgepumpt.

Anschließend wird in den Innenraum der Flasche bei einem Druck von 0,3 mbar ein Gemisch aus Sauerstoff und Hexamethyldisilazan (HMDSN) geleitet.

Danach wird gepulste Mikrowellenenergie mit einer Frequenz von 2,45 GHz eingekoppelt und ein Plasma im Behälter gezündet.

Zunächst wird in einer Beschichtungszeit von unterhalb von 1 Sekunde eine erste 10 nm dicke organische Barriereschicht bei einer HMDSN-Konzentration von 40 % und einem Gesamtfluss von 40 sccm aufgebracht.

Die Pulsleistung beträgt 800 W, die Pulsdauer bevorzugt 0,7 ms und die Pulspause beträgt 40 ms.

Anschließend erfolgt ein schneller Gaswechsel auf eine niedrigere HMDSN-Konzentration von 1,2 %. Es wird eine zweite anorganische Barriereschicht bei gleichem vorgegebenem Druck aufgebracht.

Nach der Methode der statistischen Versuchsplanung werden in Screening-Versuchen bei konstant gehaltener HMDSN-Konzentration und konstantem Druck die Parameter Schichtdicke bzw. Beschichtungszeit und die weiteren Prozessparameter Sauerstoffflusseund Pulsleitung, Pulsdauer und Pulspause sowie der Anlagenparameters Lanzenlänge variiert.

In Fig. 1 ist ein Vergleich zwischen dem eingestellten Sauerstofffluss und der gemessenen Abscheiderate dargestellt.

Mit zunehmendem Sauerstofffluss kann die Abscheiderate der zweiten anorganischen Schicht deutlich gesteigert werden.

Tabelle 1 zeigt eine Auswahl von untersuchten Prozessparametern für die zweite anorganische Schicht, bei welchen der Verbund aus erster und zweiter Schicht eine hohe Barrierewirkung ergibt.

Ferner ist die Beschichtungszeit und Abscheiderate der zweiten anorganischen Schicht in Abhängigkeit von Prozess- und Anlagenparametern sowie Charakterisierung der Barriereverbesserung des Zweischicht-Verbundes aus erster organischer und zweiter anorganischer Schicht, direkt nach der Beschichtung sowie nach einem Belastungstest (Creep-Test mit 4 Vol.-% CO₂) ausgeführt.

**Tabelle 1 Beschichtungszeit und Abscheiderate der 2. anorganischen Schicht abhängig von Prozess- und Anlagepa.rametem sowie Barrfereverbesserungs (BIF) des 2-Schichtverbundes aus 1. organischer und 2. anorganischer Schicht, direkt nach der Beschichtung und nach einem Belastungstest (4 % Creep-Test mit 4 Vol.-% CO₂).**

| **Prozess** | **Lanzen -länge** | **Dicke 2.Schicht** | **O₂-Fluss** | **Puls-leistung** | **Pulsdauer Barriere** | **Pulspause Barriere** | **Beschich-tungszeit** | **Abscheiden-Rate** | **O₂-BIF** | **O₂-BIF** |
|---|---|---|---|---|---|---|---|---|---|---|
| | (mm) | (nm) | (sccm) | (W) | (ms) | (ms) | (s) | (nm/min) | **für 2-Schicht,-Verbund** | **nach 4% Creep-Test** |
| 1 | 120 | 20 | 100 | 800 | 3 | 50 | 14 | 86 | > 40 | 4 |
| 2 | 50 | 20 | 220 | 800 | 3,5 | 40 | 6 | 200 | > 40 | 5 |
| 3 | 50 | 17,5 | 380 | 850 | 3,5 | 40 | 3 | 318 | > 40 | 5 |
| 4 | 50 | 12 | 450 | 900 | 4 | 40 | 2 | 360 | 30 | 4 |

In vorstehender Tabelle ist der Barriereverbesserungsfaktor, Barrier improvement Factor, BIF, als das Verhältnis der Permeation eines unbeschichteten Substrats relativ zu der Permeation eines beschichteten Substrats definiert.

Aus den Daten geht hervor, dass bei Prozess 1, bei dem der Sauerstofffluss 100 sccm, die Pulspause 50 ms und die Lanzenlänge 102 mm beträgt, eine Abscheiderate von 86 nm/min erreicht wird.

Die Beschichtungszeit ist mit 14 s relativ lang. Dagegen sind die Abscheideraten der Prozesse 2, 3 und 4 mit 200, 318 bzw. 360 nm/min aufgrund der höheren Sauerstoffflüsse von 220, 380 bzw. 450 sccm und aufgrund der auf 40 ms verkürzten Pulspause, sowie der verbesserten Lanzenlänge von 50 mm deutlich höher.

Es kann folglich die Beschichtungszeit deutlich reduziert werden.

Ferner ist zur weiteren Prozesszeitverkürzung die Dicke der zweiten Schicht verringert worden. Insgesamt wird dadurch die resultierende Beschichtungszeit auf Werte von 2 bis 6 Sekunden reduziert.

Durch die Beschichtung kann ein Haftvermittler-Barriereverbund mit einem hohen Sauerstoffbarriereverbesserungsfaktor (O₂-BIF) hergestellt werden, der einen Wert von deutlich > 40 für die Prozesse 1, 2 und 3 besitzt.

Die Permeation einer unbeschichteten Flasche beträgt 0,1955 cm³/(Packung Tag·bar). Die Permeation der beschichteten Flasche ist so niedrig, dass die Auflösungsgrenze des verwendeten Mocon-Oxtran-Messgerätes erreicht worden ist.

Für den Prozess 4 mit der kürzesten Beschichtungszeit der zweiten Schicht von 2 s wird ein O₂-BIF von 30 bestimmt.

Diese Schichten sind sehr haftfest und dehnbeständig, wie folgender Creep-Test verdeutlicht.

Die beschichteten Flaschen werden für den Creep-Test mit 0,4 l karbonisierter Flüssigkeit mit einem CO₂-Anteil von 4 % befüllt und mit einer Kunststoffkappe verschlossen. Anschließend werden die befüllten Flaschen zunächst 24 Stunden bei Raumtemperatur und anschließend 24 Stunden bei 38°C gelagert.

Bei dem Testverfahren entsteht in der Flasche ein Innendruck von bis zu 5 bar, wodurch der Schicht-/Substratverbund um lokal mehr als 4,5 % gedehnt und sogar plastisch verformt wird. Durch die hohen Dehnungen und/oder plastischen Verformungen wird die Barriereverbesserung reduziert, was auf Veränderungen im Schichtverbund in Bereichen extrem starker Dehnungen zurückzuführen ist.

Jedoch ist der Verbund so stabil, dass eine deutlich nachweisbare Barrierewirkung trotz dieser hohen Belastung erhalten bleibt. Dieser Effekt ist darauf zurückzuführen, dass trotz der hohen Dehnung und/oder plastischen Verformung keine Schichtablösung aufgrund der guten Haftung auftritt, und für einen Großteil der Oberfläche des beschichteten Substrats keine Rissbildung im Schichtverbund entsteht, durch die die Sperrwirkung verschlechtert wird.

Nach dem Creep-Test wird erneut der O2-BIF bestimmt. In Tabelle 1 sind die ermittelten Werte gezeigt: die gegenüber Prozess 1 deutlich verkürzten Prozesse 2 und 3 ermöglichen eine vergleichbar gute, nach dem Creep-Test sogar leicht verbesserte Barrierewirkung gegenüber Prozess1.

Der schnellste Prozess hat eine leicht reduzierte, aber immer noch sehr hohe Barriereverbesserung nach der Beschichtung und eine genau so gute Barriereverbesserung nach dem Creep-Test wie der langsamere Prozess 1.

### Ausführungsbeispiel 2

### Wechselschichten aus alternierenden organischen und anorganischen Schichten

Zum Aufbringen von Wechselschichten aus alternierenden organischen und anorganischen Schichten werden die Prozesse aus dem ersten Ausführungsbeispiel mehrfach wiederholt.

Nach dem Aufbringen einer organischen Barriereschicht, einem schnellen Gaswechsel und dem Aufbringen einer anorganischen Barriereschicht erfolgt erneut ein Gaswechsel, bei dem auf die Beschichtungsparameter der organischen Schicht umgestellt wird.

Anschließend wird der Vorgang mit den genannten Schritten mindestens einmal wiederholt. Die abgeschiedenen Wechselschichten weisen eine hohe Barrierewirkung und eine sehr gute mechanische Belastbarkeit auf.

### Ausführungsbeispiel 3

### Schnelle Beschichtung einer HOT-FILL-Flasche

Eine HOT-FILL-Flasche aus kristallinem PET mit einem Volumen von 0,5 1 wird mit den gleichen Prozessparametern wie bei Prozess 2 aus Ausführungsbeispiel 1 beschichtet. Als HOT-FILL-Flasche wird hierbei wie üblich eine heißbefüllbare Flasche bezeichnet, welche bei einer Befüllung mit einer Flüssigkeit einer Temperatur zwischen 85° C und 95° C im wesentlichen keine Größenänderung zeigt.

Aufgrund der veränderten Flaschenform ändert sich dabei jedoch die Abscheiderate.

Um die Flasche mit im wesentlichen gleichen Schichtdicken wie in Ausführungsbeispiel 1 zu beschichten, ergibt sich eine Beschichtungszeit von 1,3 s für die erste organische Schicht, und von 5,3 s für die zweite anorganische Schicht.

Direkt nach der Beschichtung besitzt der Behälter eine hohe Barrierewirkung. Eine unbeschichtete HOT-FILL-Flasche hat eine Sauerstoffpermeation von 0,192 cm³/(Packung·Tag·bar), eine. beschichtete Flaschen besitz eine Sauerstoffpermeation unterhalb der Nachweisgrenze von 0,04 cm³/(Packung Tag bar) und damit einen O₂-BIF von mehr als 40.

In einem Belastungstest werden beschichtete Flaschen zunächst eine Stunde bei 35°C und 95 % relativer Luftfeuchtigkeit gelagert. Anschließend werden die Flaschen auf 0,5 1 mit 95°C heißem Wasser befüllt, die Temperatur wird zunächst 5 Minuten liegend beibehalten und anschließend wird der befüllte Behälter im kalten Wasserbad 20 Minuten lang auf Raumtemperatur abgekühlt.

Nach diesem Belastungstest zur Heißabfüllung wird die Sauerstoffpermeation der Proben bestimmt.

Es ergibt sich hierbei ein O₂-BIF von 9 nach dem Belastungstest. Durch diesen Test wird gezeigt, dass die Beschichtung gegen Heißabfüllung beständig ist, denn es sind keine Ablösungen der Schicht zu beobachten, und es bleibt die gute Barrierewirkung nach der Heißabfüllung erhalten.

### Ausführungsbeispiel 4

### Schnelle Innenbeschichtung einer 0,6 1 PP-Flasche mit einem Haftvermittlerbarriereverbund

Eine Flasche aus Polypropylen (PP) mit einem Füllvolumen von 0,6 1 wird mit den gleichen Prozessparametern wie bei Prozess 2 aus Ausführungsbeispiel 1 beschichtet. Aufgrund der veränderten Flaschenform ändert sich die Abscheiderate.

Um die Flasche mit den gleichen Schichtdicken wie in Ausführungsbeispiel 1 zu beschichten, ergibt sich eine Beschichtungszeit von 1 s für die erste organische Schicht, und von 5,6 s für die zweite anorganische Schicht. Durch die Beschichtung kann ein Haftvermittlerbarriereverbund mit einem hohen O₂-Barriereverbesserungsfaktor (O₂-BIF) hergestellt werden.

Die Schichten sind sehr haftfest und dehnbeständig. Es ist im vorliegenden Fall keine Plasmavorbehandlung oder eine Aktivierung des Substrats, wie sie zum Beispiel mit einem Sauerstoffplasma erfolgen könnte, erforderlich.

## Patentansprüche

1. Verfahren zum Aufbringen von Wechselschichten durch Mikrowellen-Plasma-unterstützte chemische Gasphasenabscheidung,
welches die Verfahrensschritte des Abscheidens einer organischen Haftvermittlerschicht auf einem als Hohlkörper ausgestalteten Substrat, und des Aufbringens einer anorganischen Sperrschicht umfaßt, wobei alternierend Wechselschichten aus organischen und anorganischen Materialien aus einem Gasgemisch abgeschieden werden, welches Sauerstoff und mindestens eine siliziumhaltige organische Verbindung enthält,
wobei die Wechselschichten allein aus einem Precursormaterial in Form eines einzigen Precursorgases aus HMDSN oder HMDSO hergestellt werden,
und wobei als erste Schicht eine organische Haftvermittlerschicht auf den Hohlkörper aufgebracht wird und als zweite Schicht eine anorganische Sperrschicht aufgebracht wird und wobei ein
transparentes Verbundmaterial hergestellt wird,
und wobei die Beschichtungszeit zum Aufbringen der organischen Haftvermittlerschicht zwischen 0,05 s bis 4,0 s liegt, und/oder die Beschichtungszeit zum Aufbringen der anorganischen Sperrschicht zwischen 0,1 s bis 6,0 s liegt wobei die Precursorkonzentration zum Aufbringen der organischen Haftvermittlerschicht im Bereich von 5 % bis 80 % des Gesamtflusses liegt und wobei die Precursorkonzentration zum Aufbringen der Sperrschicht im Bereich von 0,5 % bis 4 % liegt **dadurch gekennzeichnet, dass**
das Plasma gepulst wird und die Pulspause für die organische Schicht im Bereich von 2 ms bis 100 ms und für die anorganische Schicht zwischen 5 ms und 200 ms liegt.

2. verfahren nach Anspruch 1,
**dadurch gekennzeichnet, dass** die Wechselschichten durch Variation von mindestens einem, vorzugsweise mindestens 2 Prozeßparametern abgeschieden werden.

3. Verfahren nach Anspruch 1 oder 2,
**dadurch gekennzeichnet, dass** beim Abscheiden der Schichten ein mit einer Frequenz von 2,45 GHz erzeugtes Plasma eingesetzt wird.

4. Verfahren nach einem der vorstehenden Ansprüche,
**dadurch gekennzeichnet, dass** der oder die zu variierenden Prozeßparameter aus der Gruppe ausgewählt sind, welche die Precursorkonzentration, die mittlere Mikrowellenleistung, den Druck, den Gesamtfluß, die Pulsleistung, die Pulsdauer und die Dauer der Pulspause umfaßt.

5. Verfahren nach einem der vorstehenden Ansprüche,
**dadurch gekennzeichnet, dass** die Precursorkonzentration zum Aufbringen der Sperrschicht zwischen 0,8 % und 3 % des Gesamtflusses liegt.

6. Verfahren nach einem der vorstehenden Ansprüche,
**dadurch gekennzeichnet, dass** die Pulspause für die organische Schicht im Bereich von 5 ms und 60 ms liegt und für die anorganische Schicht zwischen, 20 ms und 50 ms liegt.

7. Verfahren nach einem der vorstehenden Ansprüche,
**dadurch gekennzeichnet, dass** die Pulsleistung für die organische Schicht im Bereich von 100 W bis 5000 W, vorzugsweise im Bereich von 400 W und 1500 W liegt, und/oder die Pulsleistung für die zweite anorganische Schicht im Bereich von 100 W bis 5000 W, vorzugsweise im Bereich von 400 W bis 1500 W liegt.

8. Verfahren nach einem der vorstehenden Ansprüche,
**dadurch gekennzeichnet, dass** die mittlere Mikrowellenleistung für die organische Schicht im Bereich von 10 W und 5000 W, vorzugsweise im Bereich von 10 W und 500 W liegt, und/oder die mittlere Mikrowellenleistung für die anorganische Schicht im Bereich von 10 W bis 5000 W, vorzugsweise im Bereich von 30 W und 2000 W liegt.

9. Verfahren nach einem der vorstehenden Ansprüche,
**dadurch gekennzeichnet, dass** als Substrat ein Hohlkörper, vorzugsweise gleichzeitig, außenseitig auf einen Druck p₁ evakuiert und innenseitig auf einen Basisdruck p₂ < p₁ abgepumpt wird, wobei der Druck p₁ insbesondere im Bereich von 10 bis 50 mbar, und der Basisdruck p₂ insbesondere unterhalb von 1 mbar, vorzugsweise unterhalb von 0,5 mbar liegt.

10. Verfahren nach einem der vorstehenden Ansprüche,
**dadurch gekennzeichnet, dass** ein den Precursor enthaltendes Gasgemisch bei einem Druck p₃ mit p₂ < p₃ < p₁ in den Innenraum des Substrats geleitet wird, wobei der Druck p₃ insbesondere im Bereich von 0,2 mbar bis 1,0 mbar liegt.

11. Verfahren nach einem der vorstehenden Ansprüche,
**dadurch gekennzeichnet, dass** der Gesamtfluß und/oder der Druck p₃ im Innenraum des Substrats beim Abscheiden der anorganischen Sperrschicht zumindest gleich, insbesondere höher ist als der Gesamtfluß und/oder der Druck p₃ im Innenraum des Substrats beim Abscheiden der organischen Haftvermittlerschicht.

12. Verfahren nach einem der vorstehenden Ansprüche,
**dadurch gekennzeichnet, dass** der Druck p₃ für die erste organische Schicht im Bereich von 0,1 mbar bis 1,0 mbar, vorzugsweise im Bereich von 0,2 mbar bis 0,5 mbar, und für die zweite anorganische Schicht im Bereich von 0,1 mbar bis 1,0 mbar, vorzugsweise im Bereich von 0,25 mbar bis 0,6 mbar liegt.

13. Verfahren nach einem der vorstehenden Ansprüche,
**dadurch gekennzeichnet, dass** die Lanzenlänge im Bereich von 5 % bis 80 %, vorzugsweise im Bereich von 10 % bis 50 % der Höhe eines zu beschichtenden Substrats liegt.

14. Verfahren nach einem der vorstehenden Ansprüche,
**dadurch gekennzeichnet, dass** der Gesamtfluss für die organische Haftvermittlerschicht im Bereich von 10 sccm bis 250 sccm, vorzugsweise im Bereich von 40 sccm bis 100 sccm liegt, und der Gesamtfluss für die anorganische Schicht im Bereich von 200 sccm bis 1000 sccm, vorzugsweise im Bereich von 250 sccm bis 400 sccm liegt.

15. Verfahren nach einem der vorstehenden Ansprüche,
**dadurch gekennzeichnet, dass** jeweils das Prozeßgas für eine Schicht bei einem Druck p₄ eingelassen wird, welcher höher ist als der Druck p₅ unmittelbar vor dem Zünden des Plasmas.

16. Verfahren nach einem der vorstehenden Ansprüche,
**dadurch gekennzeichnet, dass** der Prozeßdruck während des Aufbringens einer Schicht bis zum Beginn des Aufbringens der folgenden Schicht kontinuierlich fällt.

17. Verfahren nach einem der vorstehenden Ansprüche,
**dadurch gekennzeichnet, dass** die Temperatur während des Aufbringens der Beschichtung kontinuierlich steigt.

18. Verfahren nach einem der vorstehenden Ansprüche,
**dadurch gekennzeichnet, dass** beim Wechsel der Prozeßparameter beim Übergang zwischen zwei Beschichtungsschritten das Plasma weiter brennt.

19. Verfahren nach einem der vorstehenden Ansprüche von 1 bis 18, **dadurch gekennzeichnet, dass** beim Wechsel der Prozeßparameter beim Übergang zwischen zwei Beschichtungsschritten das Plasma für eine Übergangszeit, die insbesondere im Bereich von 0 und 1,0 s vorzugsweise zwischen 0,005 s und 0,5 s liegt, unterbrochen wird.

20. Verfahren nach einem der vorstehenden Ansprüche,
**dadurch gekennzeichnet, dass** die Übergangszeit für das gepulste Plasma größer als die Pulspause ist.

21. Verfahren nach einem der vorstehenden Ansprüche,
**dadurch gekennzeichnet, dass** vor dem Aufbringen der Beschichtung eine Plasmavorbehandlung durchgeführt wird, deren Dauer unterhalb von 5 s, vorzugsweise unterhalb 1s liegt.

22. Verfahren nach einem der vorstehenden Ansprüche,
**dadurch gekennzeichnet, dass** der zumindest eine Prozeßparameter kontinuierlich variiert wird.

23. Verfahren nach einem der vorstehenden Ansprüche,
**dadurch gekennzeichnet, dass** der zumindest eine Prozeßparameter diskontinuierlich variiert wird.

24. Verfahren nach einem der vorstehenden Ansprüche,
**dadurch gekennzeichnet, dass** der zumindest eine Prozeßparameter teilweise kontinuierlich und teilweise diskontinuierlich variiert wird.

25. Verfahren nach einem der vorstehenden Ansprüche,
**dadurch gekennzeichnet, dass** die Sperrwirkung durch ein Verlängern der Diffusionswege erreicht wird.

26. Verfahren nach einem der vorstehenden Ansprüche,
**dadurch gekennzeichnet, dass** die Verfahrensschritte des Aufbringens einer ersten und einer zweiten Schicht wiederholt werden.

27. Verfahren nach einem der vorstehenden Ansprüche,
**dadurch gekennzeichnet, dass** die Wechselschichten auf einem dielektrischen Material abgeschieden werden.

28. Verfahren nach Anspruch 27,
**dadurch gekennzeichnet, dass** die Wechselschichten auf Kunststoff abgeschieden werden.

29. Verfahren nach einem der vorstehenden Ansprüche,
**dadurch gekennzeichnet, dass** die Abscheiderate für die organische Schicht im Bereich von 120 nm/min bis 5000 nm/min, vorzugsweise im Bereich von 500 nm/min bis 2000 nm/min liegt, und/oder die Abscheiderate für die anorganische Schicht im Bereich von 60 nm/min bis 2000 nm/min, vorzugsweise im Bereich von 100 nm/min bis 1000 nm/min liegt.

30. Transparentes Verbundmaterial bestehend aus einem als Hohlkörper ausgebildetem Substrat und zumindest einer Wechselschicht aus organischer und anorganischer Beschichtung,
wobei die zumindest eine Wechselschicht mit einem Verfahren gemäß einem der vorstehenden Ansprüche von 1 bis 29 aufgebracht ist und welches gegenüber einem nicht beschichteten aber ansonsten gleichen Material **gekennzeichnet ist durch** eine erhöhte Barrierewirkung, und/oder eine erhöhte Haftung, eine erhöhte Dehnbarkeit, eine erhöhte mechanische Stabilität des Schicht-Substratverbundes unter Druckbelastung und/oder eine erhöhte mechanische Stabilität unter Dehnbelastung und/oder plastischer Verformung während und nach der Belastung, derart, dass nach Dehnungen und/oder plastischen Verformungen mit Längenänderungen von mehr als 4 % eine Barriereverbesserung mit einem Sauerstoffbarriereverbesserungsfaktor größer als 1,5 vorzugsweise größer als 2,0, verbleibt.

31. Verbundmaterial nach Anspruch 30,
**dadurch gekennzeichnet, dass** die organische Haftvermittlerschicht eine Dicke von 1 nm bis 200 nm, vorzugsweise eine Dicke von 2 nm bis 50 nm aufweist, und/oder dass die anorganische Sperrschicht eine Dicke von 5 nm bis 200 nm, vorzugsweise eine Dicke von 5 nm bis 50 nm aufweist.

32. Verbundmaterial nach einem der Ansprüche 30 bis 31 **dadurch gekennzeichnet, dass** das Verbundmaterial temperaturbeständig ist, insbesondere bei Temperaturbelastung durch eine Heißabfüllung.

33. Verbundmaterial nach einem der Ansprüche 30 bis 32, **dadurch gekennzeichnet, dass** das Verbundmaterial zusätzlich zu der zumindest einen Wechselschicht aus organischer und anorganischer Beschichtung eine Deckschicht umfaßt.

## Claims

1. Method for applying alternating layers by microwave plasma-assisted chemical vapour deposition, comprising the method steps of depositing an organic adhesion-promoting layer on a substrate formed as a hollow body, and applying an inorganic barrier layer, wherein alternating layers of organic and inorganic materials are alternately deposited from a gas mixture containing oxygen and at least one silicon-containing organic compound,
wherein the alternating layers are produced solely from a precursor material in the form of a single precursor gas consisting of HMDSN or HMDSO,
and wherein an organic adhesion-promoting layer is applied onto the hollow body as the first layer and an inorganic barrier layer is applied as the second layer, and wherein a transparent composite material is produced,
and wherein the coating time for applying the organic adhesion-promoting layer is between 0.05 s to 4.0 s, and/or the coating time for applying the inorganic barrier layer is between 0.1 s to 6.0 s, wherein the precursor concentration for applying the organic adhesion-promoting layer is in the range of 5% to 80% of the total flow, and wherein the precursor concentration for applying the barrier layer is in the range of 0.5% to 4%,
**characterised in that**
the plasma is pulsed and the pulse pause for the organic layer is in the range of 2 ms to 100 ms and the pulse pause for the inorganic layer is between 5 ms and 200 ms.

2. Method as claimed in claim 1, **characterised in that** the alternating layers are deposited by varying at least one, preferably at least 2, process parameters.

3. Method as claimed in claim 1 or 2, **characterised in that** a plasma produced at a frequency of 2.45 GHz is used when depositing the layers.

4. Method as claimed in any one of the preceding claims, **characterised in that** the process parameter(s) to be varied are selected from the group including precursor concentration, average microwave power, pressure, total flow, pulse power, pulse duration and duration of the pulse pause.

5. Method as claimed in any one of the preceding claims, **characterised in that** the precursor concentration for applying the barrier layer is between 0.8% and 3% of the total flow.

6. Method as claimed in any one of the preceding claims, **characterised in that** the pulse pause for the organic layer is in the range of 5 ms and 60 ms and the pulse pause for the inorganic layer is between 20 ms and 50 ms.

7. Method as claimed in any one of the preceding claims, **characterised in that** the pulse power for the organic layer is in the range of 100 W to 5000 W, preferably in the range of 400 W and 1500 W, and/or the pulse power for the second inorganic layer is in the range of 100 W to 5000 W, preferably in the range of 400 W to 1500 W.

8. Method as claimed in any one of the preceding claims, **characterised in that** the average microwave power for the organic layer is in the range of 10 W and 5000 W, preferably in the range of 10 W and 500 W, and/or the average microwave power for the inorganic layer is in the range of 10 W to 5000 W, preferably in the range of 30 W and 2000 W.

9. Method as claimed in any one of the preceding claims, **characterised in that**, as a substrate, a hollow body is evacuated on the outside to a pressure p₁ and, preferably simultaneously, is pumped down on the inside to a base pressure p₂ < p₁, wherein the pressure p₁ is in particular in the range of 10 to 50 mbar, and the base pressure p₂ is in particular less than 1 mbar, preferably less than 0.5 mbar.

10. Method as claimed in any one of the preceding claims, **characterised in that** a gas mixture containing the precursor is fed to the interior of the substrate at a pressure p₃, where p₂ < p₃ < p₁, wherein the pressure p₃ is in particular in the range of 0.2 mbar to 1.0 mbar.

11. Method as claimed in any one of the preceding claims, **characterised in that** the total flow and/or the pressure p₃ in the interior of the substrate when depositing the inorganic barrier layer is/are at least identical to, in particular higher than, the total flow and/or the pressure p₃ in the interior of the substrate when depositing the organic adhesion-promoting layer.

12. Method as claimed in any one of the preceding claims, **characterised in that** the pressure p₃ for the first organic layer is in the range of 0.1 mbar to 1.0 mbar, preferably in the range of 0.2 mbar to 0.5 mbar, and the pressure p₃ for the second inorganic layer is in the range of 0.1 mbar to 1.0 mbar, preferably in the range of 0.25 mbar to 0.6 mbar.

13. Method as claimed in any one of the preceding claims, **characterised in that** the lance length is in the range of 5% to 80%, preferably in the range of 10% to 50% of the height of a substrate to be coated.

14. Method as claimed in any one of the preceding claims, **characterised in that** the total flow for the organic adhesion-promoting layer is in the range of 10 sccm to 250 sccm, preferably in the range of 40 sccm to 100 sccm, and the total flow for the inorganic layer is in the range of 200 sccm to 1000 sccm, preferably in the range of 250 sccm to 400 sccm.

15. Method as claimed in any one of the preceding claims, **characterised in that** in each case the process gas for one layer is let in at a pressure p₄ which is higher than the pressure p₅ immediately prior to igniting the plasma.

16. Method as claimed in any one of the preceding claims, **characterised in that** the process pressure continuously falls during the application of a layer until the beginning of the application of the following layer.

17. Method as claimed in any one of the preceding claims, **characterised in that** the temperature continuously increases during the application of the coating.

18. Method as claimed in any one of the preceding claims, **characterised in that** the plasma further burns as the process parameters change when transitioning between two coating steps.

19. Method as claimed in any one of the preceding claims 1 to 18, **characterised in that** the plasma is interrupted for a transition time, in particular in the range of 0 and 1.0 s, preferably between 0.005 s and 0.5 s as the process parameters change when transitioning between two coating steps.

20. Method as claimed in any one of the preceding claims, **characterised in that** the transition time for the pulsed plasma is greater than the pulse pause.

21. Method as claimed in any one of the preceding claims, **characterised in that** prior to applying the coating, a plasma pre-treatment is effected, the length of which is less than 5 s, preferably less than 1 s.

22. Method as claimed in any one of the preceding claims, **characterised in that** the at least one process parameter is continuously varied.

23. Method as claimed in any one of the preceding claims, **characterised in that** the at least one process parameter is discontinuously varied.

24. Method as claimed in any one of the preceding claims, **characterised in that** the at least one process parameter is partially continuously and partially discontinuously varied.

25. Method as claimed in any one of the preceding claims, **characterised in that** the barrier effect is achieved by extending the diffusion paths.

26. Method as claimed in any one of the preceding claims, **characterised in that** the method steps of applying a first layer and applying a second layer are repeated.

27. Method as claimed in any one of the preceding claims, **characterised in that** the alternating layers are deposited on a dielectric material.

28. Method as claimed in claim 27, **characterised in that** the alternating layers are deposited on a synthetic material.

29. Method as claimed in any one of the preceding claims, **characterised in that** the deposition rate for the organic layer is in the range of 120 nm/min to 5000 nm/min, preferably in the range of 500 nm/min to 2000 nm/min, and/or the deposition rate for the inorganic layer is in the range of 60 nm/min to 2000 nm/min, preferably in the range of 100 nm/min to 1000 nm/min.

30. Transparent composite material consisting of a substrate formed as a hollow body and at least one alternating layer consisting of an organic and inorganic coating,
wherein the at least one alternating layer is applied by means of a method as claimed in any one of the preceding claims 1 to 29 and, compared with a non-coated but otherwise identical material, is **characterised by** an increased barrier effect and/or an increased adhesion, an increased extensibility, an increased mechanical stability of the layer-substrate composite under compressive load, and/or an increased mechanical stability under strain and/or plastic deformation during and after the loading, such that after stretching and/or plastic deformation with length changes of more than 4% a barrier improvement with an oxygen barrier improvement factor of greater than 1.5, preferably greater than 2.0, is retained.

31. Composite material as claimed in claim 30, **characterised in that** the organic adhesion-promoting layer has a thickness of 1 nm to 200 nm, preferably a thickness of 2 nm to 50 nm, and/or **in that** the inorganic barrier layer has a thickness of 5 nm to 200 nm, preferably a thickness of 5 nm to 50 nm.

32. Composite material as claimed in any one of claims 30 to 31, **characterised in that** the composite material is temperature-resistant, in particular under a thermal load caused by hot-filling.

33. Composite material as claimed in any one of claims 30 to 32, **characterised in that** the composite material includes, in addition to the at least one alternating layer consisting of an organic and inorganic coating, a cover layer.

## Revendications

1. Procédé d'application de couches alternées par dépôt chimique en phase gazeuse assisté par plasma micro-onde, comprenant les étapes de dépôt d'une couche d'agent adhésif organique sur un substrat réalisé comme corps creux, et d'application d'une couche de barrière inorganique, des couches alternées de matériaux organiques et inorganiques étant déposées en alternance à partir d'un mélange gazeux contenant de l'oxygène et au moins un composé organique à teneur en silicium, les couches alternées étant produites seulement à partir d'un matériau précurseur sous la forme d'un gaz précurseur unique à base de HMDSN ou de HMDSO, une couche d'agent adhésif organique étant appliquée sur le corps creux en tant que première couche et une couche de barrière inorganique étant appliquée en tant que deuxième couche et un matériau composite transparent étant produit, et le temps de revêtement pour l'application de la couche d'agent adhésif organique étant compris entre 0,05 s et 4,0 s, et/ou le temps de revêtement pour l'application de la couche de barrière inorganique étant compris entre 0,1 s et 6,0 s, la concentration de précurseur pour l'application de la couche d'agent adhésif organique étant comprise entre 5 % et 80 % du débit total et la concentration de précurseur pour l'application de la couche de barrière étant comprise entre 0,5 % et 4 %, **caractérisé en ce que** le plasma est pulsé, et **en ce que** l'intervalle entre impulsions est compris entre 2 ms et 100 ms pour la couche organique, et entre 5 ms et 200 ms pour la couche inorganique.

2. Procédé selon la revendication 1, **caractérisé en ce que** les couches alternées sont déposées par variation d'au moins un, préférentiellement d'au moins 2 paramètres de processus.

3. Procédé selon la revendication 1 ou la revendication 2, **caractérisé en ce qu'**un plasma généré avec une fréquence de 2,45 GHz est mis en oeuvre pour le dépôt des couches.

4. Procédé selon l'une des revendications précédentes, **caractérisé en ce que** le ou les paramètres de processus à varier sont sélectionnés dans le groupe comprenant la concentration de précurseur, la puissance micro-onde moyenne, la pression, le débit total, la puissance d'impulsion, la durée d'impulsion et la durée de l'intervalle entre impulsions.

5. Procédé selon l'une des revendications précédentes, **caractérisé en ce que** la concentration de précurseur pour l'application de la couche de barrière est comprise entre 0,8 % et 3 % du débit total.

6. Procédé selon l'une des revendications précédentes, **caractérisé en ce que** l'intervalle entre impulsions est compris entre 5 ms et 60 ms pour la couche organique et entre 20 ms et 50 ms pour la couche inorganique.

7. Procédé selon l'une des revendications précédentes, **caractérisé en ce que** la puissance d'impulsion est comprise entre 100 W et 5000 W, préférentiellement entre 400 W et 1500 W pour la couche organique, et/ou la puissance d'impulsion est comprise entre 100 W et 5000 W, préférentiellement entre 400 W et 1500 W, pour la deuxième couche inorganique.

8. Procédé selon l'une des revendications précédentes, **caractérisé en ce que** la puissance micro-onde moyenne est comprise entre 10 W et 5000 W, préférentiellement entre 10 W et 500 W, pour la couche organique, et/ou la puissance micro-onde moyenne est comprise entre 10 W et 5000 W, préférentiellement entre 30 W et 2000 W, pour la couche inorganique.

9. Procédé selon l'une des revendications précédentes, **caractérisé en ce que**, préférentiellement simultanément, une dépression est produite jusqu'à une pression p₁ extérieurement sur un corps creux en tant que substrat, et celui-ci est intérieurement pompé jusqu'à une pression de base p₂ < p₁, la pression p₁ étant en particulier comprise entre 10 et 50 mbar, et la pression de base p₂ étant en particulier inférieure à 1 mbar, préférentiellement inférieure à 0,5 mbar.

10. Procédé selon l'une des revendications précédentes, **caractérisé en ce qu'**un mélange gazeux contenant le précurseur est conduit vers l'intérieur du substrat à une pression p₃, où p₂ < p₃ < p₁, la pression p₃ étant en particulier comprise entre 0,2 mbar et 1,0 mbar.

11. Procédé selon l'une des revendications précédentes, **caractérisé en ce que** le débit total et/ou la pression p₃ à l'intérieur du substrat lors du dépôt de la couche de barrière inorganique sont au moins égaux, en particulier supérieurs au débit total et/ou à la pression p₃ à l'intérieur du substrat lors du dépôt de la couche d'agent adhésif organique.

12. Procédé selon l'une des revendications précédentes, **caractérisé en ce que** la pression p₃ pour la première couche organique est comprise entre 0,1 mbar et 1,0 mbar, préférentiellement entre 0,2 mbar et 0,5 mbar, et est pour la deuxième couche inorganique comprise entre 0,1 mbar et 1,0 mbar, préférentiellement entre 0,25 mbar et 0,6 mbar.

13. Procédé selon l'une des revendications précédentes, **caractérisé en ce que** la longueur de lance est comprise entre 5 % et 80 %, préférentiellement entre 10 % et 50 %, de la hauteur d'un substrat à revêtir.

14. Procédé selon l'une des revendications précédentes, **caractérisé en ce que** le débit total pour la couche d'agent adhésif organique est compris entre 10 sccm et 250 sccm, préférentiellement entre 40 sccm et 100 sccm, et le débit total pour la couche inorganique est compris entre 200 sccm et 1000 sccm, préférentiellement entre 250 sccm et 400 sccm.

15. Procédé selon l'une des revendications précédentes, **caractérisé en ce que** le gaz de processus pour une couche est admis à une pression p₄ supérieure à la pression p₅ immédiatement avant l'allumage du plasma.

16. Procédé selon l'une des revendications précédentes, **caractérisé en ce que** la pression de processus décroît continuellement pendant l'application d'une couche jusqu'au début d'application de la couche suivante.

17. Procédé selon l'une des revendications précédentes, **caractérisé en ce que** la température croît continuellement pendant l'application du revêtement.

18. Procédé selon l'une des revendications précédentes, **caractérisé en ce que** le plasma continue à brûler à la transition entre deux étapes de revêtement en cas de changement des paramètres de processus.

19. Procédé selon l'une des revendications 1 à 18, **caractérisé en ce qu'**à la transition entre deux étapes de revêtement en cas de changement des paramètres de processus, le plasma est interrompu pour un temps de transition en particulier compris entre 0 et 1,0 s, préférentiellement entre 0,005 s et 0,5 s.

20. Procédé selon l'une des revendications précédentes, **caractérisé en ce que** le temps de transition pour le plasma pulsé est supérieur à l'intervalle entre impulsions.

21. Procédé selon l'une des revendications précédentes, **caractérisé en ce qu'**un traitement au plasma dont la durée est inférieure à 5 s, préférentiellement inférieure à 1 s, est exécuté avant l'application du revêtement.

22. Procédé selon l'une des revendications précédentes, **caractérisé en ce que** l'au moins un paramètre de processus varie de manière continue.

23. Procédé selon l'une des revendications précédentes, **caractérisé en ce que** l'au moins un paramètre de processus varie de manière discontinue.

24. Procédé selon l'une des revendications précédentes, **caractérisé en ce que** l'au moins un paramètre de processus varie en partie de manière continue et en partie de manière discontinue.

25. Procédé selon l'une des revendications précédentes, **caractérisé en ce que** l'effet de barrière est obtenu par allongement des chemins de diffusion.

26. Procédé selon l'une des revendications précédentes, **caractérisé en ce que** les étapes d'application d'une première et d'une deuxième couche sont répétées.

27. Procédé selon l'une des revendications précédentes, **caractérisé en ce que** les couches alternées sont déposées sur un matériau diélectrique.

28. Procédé selon la revendication 27, **caractérisé en ce que** les couches alternées sont déposées sur une matière plastique.

29. Procédé selon l'une des revendications précédentes, **caractérisé en ce que** la vitesse de dépôt pour la couche organique est comprise entre 120 nm/min et 5000 nm/min, préférentiellement entre 500 nm/min et 2000 nm/min, et/ou la vitesse de dépôt pour la couche inorganique est comprise entre 60 nm/min et 2000 nm/min, préférentiellement entre 100 nm/min et 1000 nm/min.

30. Matériau composite transparent constitué d'un substrat réalisé comme corps creux et d'au moins une couche alternée de revêtement organique et de revêtement inorganique, l'au moins une couche alternée étant appliquée conformément à un procédé selon l'une des revendications 1 à 29, et qui est **caractérisé, par** rapport à un matériau non revêtu quoique identique par ailleurs, par un effet de barrière accru, et/ou par une adhérence accrue, une élasticité accrue, une stabilité mécanique accrue du composite couches-substrat sous contrainte de pression et/ou une stabilité mécanique accrue sous contrainte d'étirement et/ou déformation plastique pendant et après contrainte, de telle manière qu'une optimisation de barrière avec un facteur d'optimisation de barrière à l'oxygène reste supérieur à 1,5, préférentiellement supérieur à 2,0, après étirements et/ou déformations plastiques avec des variations de longueur supérieures à 4 %.

31. Matériau composite selon la revendication 30, **caractérisé en ce que** la couche d'agent adhésif organique a une épaisseur comprise entre 1 nm et 200 nm, préférentiellement une épaisseur entre 2 nm et 50 nm, et/ou en ce que la couche de barrière inorganique a une épaisseur comprise entre 5 nm et 200 nm, préférentiellement une épaisseur entre 5 nm et 50 nm.

32. Matériau composite selon l'une des revendications 30 et 31, ledit matériau composite étant **caractérisé en ce qu'**il est thermorésistant, en particulier sous contrainte de température par remplissage à chaud.

33. Matériau composite selon l'une des revendications 30 à 32, ledit matériau composite étant **caractérisé en ce qu'**il comprend une couche de couverture en plus de l'au moins une couche alternée de revêtement organique et inorganique.
